# EUROPÄISCHE PATENTSCHRIFT

(11) **EP 2 462 620 B1**
(45) Veröffentlichungstag und Bekanntmachung des Hinweises auf die Patenterteilung: **17.05.2017**
(21) Anmeldenummer: 10721038.7
(22) Anmeldetag: 09.06.2010
(51) Int. Cl.: H01L 29/872, H01L 21/329, H01L 29/06

(54) **HALBLEITERANORDNUNG UND VERFAHREN ZU DEREN HERSTELLUNG**
SEMICONDUCTOR ARRANGEMENT AND METHOD FOR PRODUCING IT
ENSEMBLE SEMICONDUCTEUR ET SON PROCÉDÉ DE PRODUCTION

(30) Priorität: 05.08.2009 DE 102009028248
(43) Veröffentlichungstag der Anmeldung: 13.06.2012
(73) Patentinhaber: Robert Bosch GmbH, 70442 Stuttgart (DE)
(72) Erfinder: QU, Ning, 72770 Reutlingen (DE); GOERLACH, Alfred, 72127 Kusterdingen (DE)
(86) Internationale Anmeldenummer: PCT/EP2010/058067
(87) Internationale Veröffentlichungsnummer: WO 2011/015394

(56) Entgegenhaltungen:
- WO-A1-01/11693
- WO-A2-01/52306
- DE-A1-102004 053 760
- DE-T2- 69 428 996
- US-A- 6 078 090
- US-A1- 2008 315 363

## Beschreibung

### Stand der Technik

Bei dieser Erfindung handelt sich um eine **T**rench-**M**OS-**B**arrier-Schottky-Diode (TMBS) mit gefloateten p-Wannen unter dem Grabenboden als Klammerelement, die sich insbesondere als Z-Leistungsdiode mit einer Durchbruchspannung von ca. 20V für den Einsatz in Kfz-Generatorsystem eignet.

In modernen Kraftfahrzeugen werden immer mehr Funktionen mit elektrischen Bauelementen realisiert. Dadurch entsteht ein immer höherer Bedarf an elektrischer Leistung. Um diesen Bedarf zu decken, muss die Effizienz des Generatorsystems im Kfz gesteigert werden. Bis heute werden in der Regel PN-Dioden als Z-Dioden in Kfz-Generatorsystemen eingesetzt. Vorteile der PN-Dioden sind einerseits der niedrige Sperrstrom und andererseits die hohe Robustheit. Der Hauptnachteil ist die hohe Flussspannung UF. Bei Raumtemperatur beginnt Strom erst mit UF=0.7V zu fließen. Unter normaler Betriebsbedingung, z. B. einer Stromdichte von 500A/cm², steigt UF bis über 1V an, was einen unvernachlässigbaren Verlust der Generatoreffizienz bedeutet.

Theoretisch stehen Schottky-Dioden als Alternative zur Verfügung. Schottky-Dioden haben eine deutlich niedrigere Flussspannung als PN-Dioden, beispielweise 0.5V bis 0.6V bei einer hohen Stromdichte von z. B. 500A/cm². Außerdem bieten Schottky-Dioden als Majoritätsträgerbauelemente Vorteile bei schnellem Schaltbetrieb. Der Einsatz von Schottky-Dioden in Kfz-Generatorsystem erfolgt jedoch bis heute nicht. Dies ist auf einige entscheidende Nachteile von Schottky-Dioden zurückzuführen: 1) höherer Sperrstrom im Vergleich zu PN-Dioden, 2) starke Abhängigkeit des Sperrstroms von der Sperrspannung und 3) schlechte Robustheit, insbesondere bei Hochtemperatur.

Es gibt Vorschläge, Schottky-Dioden zu verbessern. Einer ist die TMBS (**T**rench-**M**OS-**B**arrier-**S**chottky-Diode), siehe T. Sakai, etc., "Experimental investigation of dependence of electrical characteristics on device parameters in Trench MOS Barrier Schottky Diodes", Proceedings of 1998 International Symposium on Power Semiconductors & ICs, Kyoto, pp. 293-296 und DE 69428996 A1.

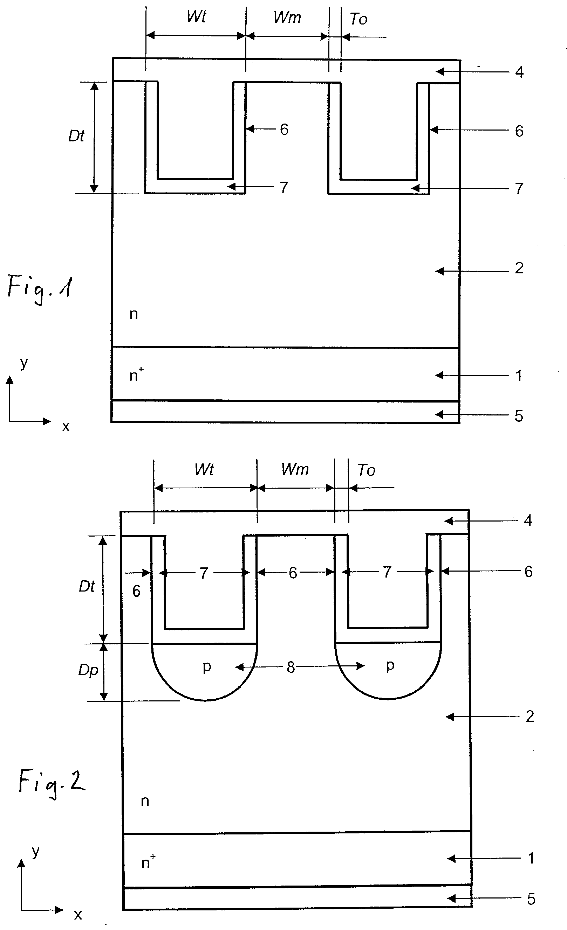

Wie Fig. 1 zeigt, besteht die TMBS aus einem n⁺-Substrat **1,** einer n-Epischicht **2,** mindestens zwei in der n-Epischicht **2** durch Ätzen realisierten Gräben (Trenchs) **6,** Metallschichten an der Vorderseite des Chips **4** als Anodenelektrode und an der Rückseite des Chips **5** als Kathodenelektrode, und Oxidschichten **7** zwischen den Gräben **6** und der Metallschicht **4.** Elektrisch gesehen ist die TMBS eine Kombination von einer MOS-Struktur mit einer Metallschicht **4,** Oxidschichten **7** und einer n-Epischicht **2** und einer Schottky-Diode mitSchottky-Barriere zwischen der Metallschicht **4** als Anode und der n-Epischicht **2** als Kathode. In der Flussrichtung fließen Ströme durch den Mesa-Bereich zwischen den Gräben **6.** Die Gräben **6** selber stehen für den Stromfluss nicht zur Verfügung. Die effektive Fläche für den Stromfluss in der Flussrichtung ist daher bei einer TMBS kleiner im Vergleich zu einer konventionellen Planar-Schottky-Diode.

Der Vorteil einer TMBS liegt in der Reduktion der Sperrströme. In der Sperrrichtung bilden sich sowohl bei der MOS-Struktur als auch bei der Schottky-Diode Raumladungszonen aus. Die Raumladungszonen dehnen sich mit steigender Spannung aus und stoßen sich bei einer Spannung, die kleiner als die Durchbruchspannung der TMBS ist, in der Mitte des Bereichs zwischen den benachbarten Gräben **6** zusammen. Dadurch werden die für hohe Sperrströme verantwortlichen Schottky-Effekte abgeschirmt und die Sperrströme reduziert. Dieser Abschirmeffekt ist stark von Strukturparametern Tiefe des Grabens *Dt,* Abstand zwischen den Gräben *Wm,* Breite des Grabens *Wt* sowie von der Dicke der Oxidschicht To abhängig, siehe Fig. 1.

Stand der Technik zur Herstellung der TMBS ist: Realisierung der Gräben **6** durch Ätzen der n-Epischicht **2,** Wachsen der Oxidschicht **7** und Ausfüllen der Gräben mit leitfähigem, dotierten Schichten aus Polysilizium. Alternativ können die Gräben mit Metall gefüllt werden. Die Ausdehnung der Raumladungszonen im Mesa-Bereich zwischen den Gräben **6** ist quasi-eindimensional, sofern die Tiefe des Grabens *Dt* deutlich größer als der Abstand zwischen den Gräben *Wm* ist.

Ein Nachteil der TMBS liegt jedoch in der Schwäche der MOS-Struktur. Beim Durchbruch entstehen sehr hohe elektrische Felder innerhalb der Oxidschicht **7** und direkt in der Nähe der Oxidschicht in der n-Epischicht **2.** Als Folge kann die MOS-Struktur durch Injektion "heißer" Ladungsträger von der n-Epischicht **2** in die Oxidschicht **7** degradiert und unter bestimmten Betriebsbedingungen sogar zerstört werden. Um diesen Nachteil zu mildern, ist es aus der WO 01/11693 A1 bekannt, eine gefloatete p-Wanne unter dem Grabenboden einzubauen. Alternativ ist aus der DE102004053760 A1 bekannt, eine p-Wanne unter dem Grabenboden einzubauen, die mit der Anodenelektrode leitend verbunden ist.

Ein weiterer Nachteil der TMBS ist die runde oder weiche Sperrkennlinie. D. h. bereits deutlich vor dem eigentlichen Durchbruch, z. B. bei einer Spannung = 70-80% der Durchbruchspannung, der Sperrstrom schon deutlich ansteigt und signifikant größer als der Sperrstrom bei kleinerer Spannung ist. Dieser große Sperrstrom im Vordurchbruch der Schottky-Diode verursacht, insbesondere bei hoher Temperatur, eine hohe Verlustleistung und kann durch positive elektrisch-thermische Rückkopplung zur thermischen Instabilität (thermal runaway) und zum Ausfall des Bauelements führen.

### Offenbarung der Erfindung

Aufgabe der Erfindung ist, Schottky-Dioden mit hoher Robustheit und kleinerer Flussspannung, geeignet als Z-Leistungsdioden für den Einsatz in Kfz-Generatorsystemen zur Verfügung zu stellen. Dabei wird durch eine integrierte Reihenschaltung von PN-Schutzdioden mit Schottkydioden ermöglicht, Schottkydioden auch zuverlässig im Spannungsdurchbruch zu betreiben. Dieser Betriebsmodus ist i. a. für den Loaddumpschutz beim Einsatz in Kfz-Genaratoren notwendig.

### Vorteile der Erfindung

Die Schottky-Diode dieser Erfindung ist eine TMBS mit gefloateten p-Wannen unter dem Grabenboden. Die PN-Diode, die aus den gefloateten p-Wannen und der n-Epischicht besteht, bestimmt die Durchbruchspannung der TMBS dieser Erfindung und funktioniert als Klammerelement. Die Auslegung der p-Wannen ist dabei so gewählt, dass die Durchbruchspannung der PN-Diode *BV_pn* niedriger als die Durchbruchspannung der Schottky-Diode *BV_schottky* und die Durchbruchspannung der MOS-Struktur *BV_mos* ist und die TMBS dieser Erfindung eine eckige Sperrkennlinie aufweist. Beim Durchbruch ist die elektrische Feldstärke in der Oxidschicht deutlich niedriger als die bei einer konventionellen TMBS.

Vorteile dieser Erfindung: Im Vergleich zur konventionellen TMBS: hohe Robustheit und Stabilität durch Klammerfunktion der integrierten PN-Diode und daher geeignet als Z-Diode für den Einsatz in Kfz-Generatorsystemen, da eine geringere Feldstärke am Oxid vorhanden ist. Die erfindungsgemäße Anordnung lässt sich durch einen modifizierten Trench Power-MOSFET Standardprozess darstellen.

Zeichnung
Fig. 1: TMBS Trench-MOS-Barrier-Schottky-Diode
Fig. 2: TMBS mit gefloateten p-Wannen unter dem Grabenboden , die nicht Teil der Erfindung ist.
Fig. 3: TMBS mit gefloateten p-Wannen unter dem Grabenboden mit Stufen-Epischicht dieser Erfindung Beschreibung der Figuren der Zeichnung

Wie Fig. 2 zeigt, besteht eine TMBS mit gefloateten p-Wannen unter dem Grabenboden aus einem n⁺-Substrat **1,** einer n-Epischicht **2,** mindestens zwei in die n-Epischicht **2** eingeätzten Gräben bzw. Trenchs **6** mit einer Breite *Wt,* einer Tiefe *Dt* und einem Abstand zwischen den benachbarten Gräben **6** *Wm*, Metallschichten an der Vorderseite des Chips **4** als Anodenelektrode und an der Rückseite des Chips **5** als Kathodenelektrode, und Oxidschichten **7** mit einer Dicke To an der Oberfläche der Gräben **6.** Unter dem Grabenboden befinden sich elektrisch floatende p-Wannen **8** mit einer Dicke *Dp,* die zusammen mit der n-Epischicht **2** PN-Übergänge bilden.

Elektrisch gesehen ist diese TMBS mit gefloateten p-Wannen unter dem Grabenboden eine Kombination von einer MOS-Struktur mit der Metallschicht **4** in Kombination mit der Oxidschicht **7** und n-Epischicht **2,** einer Schottky-Diode mit Schottky-Barriere zwischen der Metallschicht **4** als Anode und der n-Epischicht **2** als Kathode und einer PN-Diode mit einem PN-Übergang zwischen den gefloateten p-Wannen **8** als Anode und der n-Epischicht **2** als Kathode. Die gefloateten p-Wannen **8** werden so ausgelegt, dass die Durchbruchspannung der TMBS dieser Erfindung durch die Durchbruchspannung des PN-Übergangs zwischen den p-Wannen **8** und der n-Epischicht **2** bestimmt wird.

Bei der TMBS mit gefloateten p-Wannen unter dem Grabenboden fließen Ströme in der Flussrichtung, wie bei konventioneller TMBS, nur durch die Schottky-Diode, falls die Flussspannung der Schottky-Diode deutlich kleiner als Flussspannung der PN-Diode ist. In der Sperrrichtung bilden sich bei der MOS-Struktur, der Schottky-Diode und der PN-Diode Raumladungszonen aus. Die Raumladungszonen dehnen sich mit steigender Spannung sowohl in der Epischicht **2** als auch in den p-Wannen **8** aus, und stoßen sich bei einer Spannung, die kleiner als die Durchbruchspannung der TMBS ist, in der Mitte des Bereichs zwischen den benachbarten Gräben **6** zusammen. Dadurch werden die für hohe Sperrströme verantwortlichen Schottky-Effekte (Barrier Lowering) abgeschirmt und die Sperrströme reduziert. Dieser Abschirmeffekt ist von der MOS-Struktur und der p-Wannen bestimmt und stark von Strukturparametern Tiefe des Grabens *Dt,* Abstand zwischen den Gräben, Breite des Grabens *Wt*), Dicke der Oxidschicht To sowie Dicke der p-Wanne *Dp* abhängig. Im Durchbruchsbetrieb fließen Sperrströme durch die gefloateten p-Wannen und dann durch die Inversionsschicht der MOS-Struktur zum Schottky-Kontakt, d. h. die PN-Diode und die Schottky-Diode sind in Reihe geschaltet. Diese TMBS verfügt über ähnliche Abschirmwirkung von Schottky-Effekten wie eine konventionelle TMBS, bietet aber zusätzlich hohe Robustheit durch die integrierte Klammerfunktion. Die Durchbruchspannung der PN-Diode *BV_pn* wird so ausgelegt, dass *BV_pn* niedriger als die Durchbruchspannung der Schottky-Diode *BV_schottky* und die Durchbruchspannung der MOS-Struktur *BV_mos* ist und der Durchbruch am PN-Übergang zwischen den p-Wannen **8** und der n-Epischicht **2** und am Boden der p-Wannen stattfindet. Daher befindet sich die hohe elektrische Feldstärke beim Durchbruch am Boden der p-Wannen und die elektrische Feldstärke in der Nähe der MOS-Struktur ist deutlich niedriger als bei einer konventionellen TMBS. Dies ist sehr vorteilhaft für Vermeidung von Instabilität des Bauelements durch Injektion von "heißen" Ladungsträgern in die Oxidschicht **7.** Eine Drift der der Durchbruchspannung kann so vermieden werden. Deshalb ist TMBS mit gefloateten p-Wannen unter dem Grabenboden als Z-Leistungsdiode für Einsatz in Kfz-Generatorsystem gut geeignet.

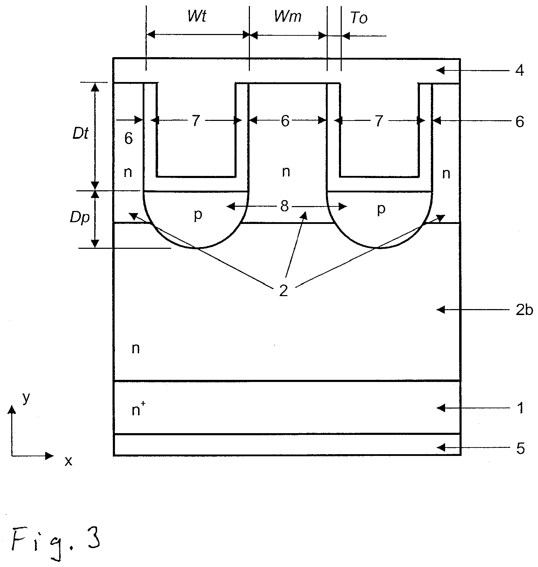

Ist die Durchbruchspannung der PN-Diode *BV_pn* deutlich kleiner als die Durchbruchspannung der Schottky-Diode *BV_schottky,* z. B. *BV_pn* = 50% von *BV_schottky,* dann wird die TMBS eine eckige Sperrkennlinie aufweisen, d. h. der sog. "Vordurchbruch" der Schottky-Diode einer konventionellen TMBS findet nicht mehr statt. Dies erhöht die Robustheit des Bauelements. Gemäß dieser Erfindung kann mit Hilfe einer Stufen-Epischicht eine eckige Sperrkennlinie sogar noch leichter realisiert werden. Wie in **Abb. 3** dargestellt, wird die n-Epischicht, anders als die Variante in Abb. 2, nicht mehr mit einer einheitlichen Dotierkonzentration realisiert, sondern von oben nach unten in zwei Bereichen unterschiedlicher Dotierkonzentrationen aufgeteilt. Die obere n-Epischicht **2** ermöglicht die höhere Durchbruchspannung der Schottky-Diode *BV_schottky* und wird schwach dotiert. Die untere n-Epischicht **2b,** in die der untere Bereich der p-Wannen eindiffundiert wird, hat eine höhere Dotierkonzentration. Der PN-Übergang zwischen den gefloateten p-Wannen und der unteren n-Epischicht verfügt daher über eine niedrigere Durchbruchspannung und bestimmt damit die Durchbruchspannung der PN-Diode und in Folge dessen die Durchbruchspannung der TMBS dieser Erfindung.

Bei der TMBS dieser Erfindung können im Randbereich des Chips noch zusätzliche Strukturen zur Reduktion der Randfeldstärke aufweisen. Dies können z. B. niedrig dotierte p-Bereiche, Feldplatten oder ähnliche dem Stand der Technik entsprechende Strukturen sein.

Ein Herstellungsverfahren von TMBS mit gefloateten p-Wannen umfasst folgende Schritte:
- n⁺-Substrat als Ausgangsmaterial
- Epitaxie
- Grabenätzen
- Oxidation der Oberfläche von Gräben
- Ätzen der Oxidschicht am Bonden der Gräben
- Diffusion p-Wanne durch den Grabenboden
- Ätzen Oxidschicht an Seitenwänden und Boden der Gräben
- Oxidation der Oberfläche von Gräben
- Auffüllen der Gräben mit dotiertem Polysilizium
- Metallisierung auf Vorder- und Rückseite.

Ein zweites Herstellungsverfahren von TMBS mit gefloateten p-Wannen umfasst folgende Schritte:
- n⁺-Substrat als Ausgangsmaterial
- Epitaxie
- Grabenätzen
- Ausfüllen der Gräben mit p-dotiertem Si oder Poly-Si bis zu einer Dicke *Dp* siehe Fig. 2 und 3),
gegebenenfalls, Ätzen Teil des p-dotierten Si oder Poly-Si in Gräben
- Oxidation der Oberfläche von Gräben
- Auffüllen der Gräben mit dotiertem Polysilizium
- Metallisierung auf Vorder- und Rückseite.

## Patentansprüche

1. Halbleiteranordnung mit einer Trench-MOS-Barrier-Schottky-Diode (TMBS) bestehend aus einem n⁺-Substrat, einer n-Epischicht (2) auf dem n⁺-Substrat, einer ersten Metallschicht (4), die mit der Epischicht (2, 2b) eine Schottky-Diode bildet, wobei die erste Metallschicht als Anodenelektrode dient und sich auf der Vorderseite des Chips befindet, und einer zweiten Metallschicht (5) die als Kathodenelektrode dient und sich auf der Rückseite des Chips befindet, wobei sich in der n-Epischicht (2, 2b) in einer zweidimensionalen Darstellungsweise mindestens zwei eingeätzte Gräben (6) befinden, wobei sich in der n-dotierten Epischicht (2) mindestens an einer Stelle unterhalb des Bodens jedes Grabens (6) eine elektrisch floatende p-dotierte Wanne (8) befindet, die als Anodenzone einer PN-Diode dient und wobei eine Oxidschicht (7) zwischen der ersten Metallschicht (4) und der Oberfläche der Gräben (6) liegt, wobei sich die n-dotierte Epischicht aus zwei unterschiedlich hoch dotierten n-Schichten zusammensetzt, einer oberen Epischicht (2), die eine schwach dotierte n-Schicht ist und einer unteren, sich an die obere Epischicht (2) anschließende Epischicht (2b), die eine höhere Dotierkonzentration aufweist als die obere Epischicht, und der untere Bereich der p-Wanne in die untere Epischicht (2b) eindiffundiert ist,
**dadurch gekennzeichnet, dass** der pn-Übergang zwischen der gefloateten p-Wanne und der unteren Epischicht eine niedrigere Durchbruchsspannung als die Schottky-Diode *(BV_schottky)* und die MOS-Struktur (*BV_mos*) der Trench-MOS-Barrier-Schottky-Diode (TMBS) aufweist und bestimmt so die Durchbruchsspannung der pn_Diode und in Folge dessen die Durchbruchsspannung der Trench-MOS-Barrier-Schottky-Diode (TMBS).

2. Halbleiteranordnung nach Anspruch 1, dadurch gegenzeichnet, dass die Durchbruchspannung der PN-Diode (*BV_pn*) *im Bereich von* 50% der Durchbruchspannung der Schottky-Diode (*BV_schottky*) liegt.

3. Halbleiteranordnung nach einem der vorhergehenden Ansprüche dadurch gegenzeichnet, dass sie eine Durchbruchsspannung im Bereich von 20V bis 40V aufweist.

4. Halbleiteranordnung nach einem der vorhergehenden Ansprüche dadurch gegenzeichnet, dass sie als Gleichrichter- und/oder Loaddumpschutzdiode in Kfz-Generatoren einsetzbar ist.

5. Halbleiteranordnung nach einem der vorhergehenden Ansprüche dadurch gegenzeichnet, dass die Gräben (6) eine rechteckige Form oder eine U-Form aufweisen.

6. Halbleiteranordnung nach einem der vorhergehenden Ansprüche dadurch gegenzeichnet, dass die Gräben (6) in Streifenanordnung oder als Inseln angeordnet sind, wobei die Inseln kreisförmig oder sechseckig gestaltet sind.

7. Halbleiteranordnung nach einem der vorhergehenden Ansprüche dadurch gegenzeichnet, dass die Metallschicht (4) an der Vorderseite des Chips die Gräben (6) ausfüllt.

## Claims

1. Semiconductor arrangement comprising a trench MOS barrier Schottky diode (TMBS) consisting of an n⁺-type substrate, an n-type epitaxial layer (2) on the n⁺-type substrate, a first metal layer (4), which together with the epitaxial layer (2, 2b) forms a Schottky diode, wherein the first metal layer serves as an anode electrode and is situated on the front side of the chip, and a second metal layer (5), which serves as a cathode electrode and is situated on the rear side of the chip, wherein, in a two-dimensional manner of representation, at least two etched-in trenches (6) are situated in the n-type epitaxial layer (2, 2b), wherein an electrically floating p-doped well (8) is situated in the n-doped epitaxial layer (2) at least at a location below the bottom of each trench (6), said well serving as an anode zone of a PN diode, and wherein an oxide layer (7) lies between the first metal layer (4) and the surface of the trenches (6), wherein the n-doped epitaxial layer is composed of two n-type layers doped to different levels, an upper epitaxial layer (2), which is a weakly doped n-type layer, and a lower epitaxial layer (2b), which is adjacent to the upper epitaxial layer (2) and which has a higher doping concentration than the upper epitaxial layer, and the lower region of the p-type well is indiffused into the lower epitaxial layer (2b), **characterized in that** the pn junction between the floating p-type well and the lower epitaxial layer has a lower breakdown voltage than the Schottky diode (*BV_schottky*) and the MOS structure (*BV_mos*) of the trench MOS barrier Schottky diode (TMBS) and thus determines the breakdown voltage of the pn diode and consequently the breakdown voltage of the trench MOS barrier Schottky diode (TMBS).

2. Semiconductor arrangement according to Claim 1, **characterized in that** the breakdown voltage of the PN diode (*BV pn*) is in the region of 50% of the breakdown voltage of the Schottky diode *(BV_schottky) .*

3. Semiconductor arrangement according to either of the preceding claims, **characterized in that** it has a breakdown voltage in the range of 20 V to 40 V.

4. Semiconductor arrangement according to any of the preceding claims, **characterized in that** it is usable as rectifier and/or load dump protective diode in motor vehicle generators.

5. Semiconductor arrangement according to any of the preceding claims, **characterized in that** the trenches (6) have a rectangular shape or a U-shape.

6. Semiconductor arrangement according to any of the preceding claims, **characterized in that** the trenches (6) are arranged in a strip arrangement or as islands, wherein the islands are of circular or hexagonal design.

7. Semiconductor arrangement according to any of the preceding claims, **characterized in that** the metal layer (4) at the front side of the chip fills the trenches (6).

## Revendications

1. Ensemble semi-conducteur comportant une diode Schottky à tranchée et barrière MOS (TMBS) constituée d'un substrat de type n⁺, d'une couche épitaxiale de type n (2) sur le substrat de type n⁺, d'une première couche métallique (4) qui forme une diode Schottky avec la couche épitaxiale (2, 2b), dans lequel la première couche métallique joue le rôle d'électrode d'anode et se trouve sur la face avant de la puce, et une deuxième couche métallique (5) qui joue le rôle d'électrode de cathode et se trouve sur la face arrière de la puce, dans lequel au moins deux tranchées gravées (6) se trouvent dans la couche épitaxiale de type n (2, 2b) dans une représentation bidimensionnelle, dans lequel une cuve (8) dopée de type p se trouve dans la couche épitaxiale dopée de type n (2) en au moins un point situé en dessous du fond de chaque tranchée (6) électriquement flottante, laquelle cuve joue le rôle de zone d'anode d'une diode PN et dans lequel une couche d'oxyde (7) se situe entre la première couche métallique (4) et la surface de la tranchée (6), dans lequel la couche épitaxiale dopée de type n se compose de deux couches de type n différentes fortement dopées, d'une couche épitaxiale supérieure (2) qui est une couche de type n faiblement dopée, et d'une couche épitaxiale (2b) inférieure se raccordant à la couche épitaxiale (2b) supérieure, qui présente une concentration de dopant plus élevée que celle de la couche épitaxiale supérieure, et dans lequel la zone inférieure de la cuve de type p pénètre par diffusion dans la couche épitaxiale (2b) inférieure,
**caractérisé en ce que** la transition pn entre la cuve de type p flottante et la couche épitaxiale inférieure présente une tension de claquage inférieure à celle de la diode Schottky (BV_Schottky) et de la structure MOS (BV_mos) de la diode Schottky à tranchée et barrière MOS (TMBS) et détermine ainsi la tension de claquage de la diode PN et par conséquent, la tension de claquage de la diode Schottky à tranchée et barrière MOS (TMBS).

2. Ensemble semi-conducteur selon la revendication 1, **caractérisé en ce que** la tension de claquage de la diode PN (BV_pn) se situe dans la plage de 50 % de la tension de claquage de la diode Schottky (BV_Schottky).

3. Ensemble semi-conducteur selon l'une quelconque des revendications précédentes, **caractérisé en ce qu'**il présente une tension de claquage se situant dans la plage de 20 V à 40 V.

4. Ensemble semi-conducteur selon l'une quelconque des revendications précédentes, **caractérisé en ce qu'**il peut être mis en oeuvre sous la forme d'une diode de redressement et/ou de protection contre les surtensions dans des alternateurs.

5. Ensemble semi-conducteur selon l'une quelconque des revendications précédentes, **caractérisé en ce que** les tranchées (6) présentent une forme rectangulaire ou une forme en U.

6. Ensemble semi-conducteur selon l'une quelconque des revendications précédentes, **caractérisé en ce que** les tranchées (6) sont disposées selon un agencement en bande ou sous forme d'îlots, dans lequel les îlots sont configurés sous forme circulaire ou hexagonale.

7. Ensemble semi-conducteur selon l'une quelconque des revendications précédentes, **caractérisé en ce que** la couche métallique (4) remplit les tranchées sur la face avant de la puce.
